# EUROPÄISCHE PATENTSCHRIFT

(11) **EP 1 432 295 B1**
(45) Veröffentlichungstag und Bekanntmachung des Hinweises auf die Patenterteilung: **13.04.2005**
(21) Anmeldenummer: 02028617.5
(22) Anmeldetag: 20.12.2002
(51) Int. Cl.: H05K 7/20, H01L 23/427

(54) **Kühlvorrichtung für eine elektrische und/oder elektronische Einheit**
Cooling device for an electric or electronic unit
Dispositif de refroidissement pour une unité électrique ou électronique

(43) Veröffentlichungstag der Anmeldung: 23.06.2004
(73) Patentinhaber: Innowert GmbH, 99610 Sömmerda (DE)
(72) Erfinder: Wellhöfer, Stefan, 99195 Schlossvippach (DE)
(74) Vertreter: Körner, Ekkehard, Dipl.-Ing.

(56) Entgegenhaltungen:
- EP-A- 0 348 838
- GB-A- 2 342 152
- US-A- 4 327 399
- US-A- 5 632 158
- US-A1- 2001 050 164

## Beschreibung

Die Erfindung betrifft eine Kühlvorrichtung für elektrische und/oder elektronische Einheiten, vor allem für solche mit hohen Wärmeleistungen.

Kühlvorrichtungen für elektrische oder elektronische Geräte werden bei modernen Hightech-Geräten mehr denn je benötigt. Insbesondere die Entwicklungen in der Computerbranche bringen immer leistungsfähigere Prozessoren hervor, die aufgrund ihrer enormen Wärmeerzeugung einer erheblichen Kühlung bedürfen. Am häufigsten wird die Kühlung von aktiven Lüftern übernommen, die zu einer unerwünschten Geräuschbildung führen, und der Ausfall eines Lüfters kann schnell zu einer Überhitzung der zu kühlenden Einheit und deren Zerstörung führen. Außerdem sind die empfindlichen elektrischen/elektronischen Einheiten bei diesen Kühlsystemen aufgrund der benötigten Luftzutrittsöffnungen im Gehäuse äußeren Einflüssen wie Staub, Feuchtigkeit usw. ausgesetzt.

Um diese Nachteile zu vermeiden, wurde vorgeschlagen, die durch die elektrischen/elektronischen Einheiten erzeugte Wärme direkt über Wärmeleitung mittels metallischer Kühlkörper abzuleiten, welche mit einem Kühlprofilkörper an der Außenwand des Gehäuses verbunden sind. Hier besteht der Nachteil, dass die Wärme vor allem über längere Strecken nur schlecht weitergeleitet wird, und somit besonders bei hohen Verlustleistungen der Komponenten eine sichere Ableitung der Wärme nicht garantiert werden kann, so dass auch hier die Gefahr der Überhitzung besteht.

In der DE 199 44 550 A1 wurde weiterhin die Verwendung von Heat Pipes zum Abtransport der von den elektrischen/elektronischen Geräten erzeugten Wärme an einen Kühlprofilkörper an der Außenwand des Gehäuses vorgeschlagen. Auch hier besteht der Nachteil, dass insbesondere bei den jüngst entwickelten Prozessoren mit enorm hohen Wärmeleistungen die Kühlung nicht mehr ausreicht, um einen sicheren Abtransport der Wärme zu gewährleisten. Außerdem werden mehrere Einzelteile (Heat Pipe, Kühlprofilkörper) eingesetzt, die relativ teuer sind und viel Platz beanspruchen, weil die Konfiguration des Kühlsystems je nach Art und Lage der zu kühlenden Einheit immer neu angeordnet werden muss. Schließlich ist der Kühlprofilkörper an der Außenwand des Gehäuses angebracht, so dass für einen ästhetischen Gesamteindruck des Gehäuses ein großer zusätzlicher Aufwand betrieben werden muss.

Aus der den nächstkommenden Stand der Technik bildenden GB-A-2 342 152 ist eine plattenförmige Heat Pipe für die Kühlung von ebenen Halbleiterplatten bekannt, die aus einem länglichen Behälter besteht, der einen wärmeleitenden Grundkörper im Inneren aufnimmt, wobei der Grundkörper direkt mit den längsseitigen Innenwänden des Behälters verbunden ist. Die obere Innenwand des Behälters ist mit einer dochtförmigen Kapillarstruktur ausgekleidet, die zur Aufnahme der sich im Inneren des Behälters befindlichen, bei Betrieb verdampfenden Flüssigkeit dient und diese zum Grundkörper zurückführt. Durch die Verdampfung der Flüssigkeit und durch Wärmeleitung wird Wärme vom Grundkörper zu der oberen Hauptfläche des Behälters transportiert, die nicht mit dem zu kühlenden Element in Berührung kommt, und dort über ein Kühlprofil abgeleitet.

Die EP 0 348 838 A2 offenbart ebenfalls eine Heat Pipe, insbesondere für auf Leiterplatten angebrachte elektronische Baulelemente, die einen geschlossenen zylinderischen Behälter mit flexibler, in Balgform ausgeführter Hülle aufweist. Der Kühlprofilkörper ist im Betrieb in direktem Kontakt mit der Stirnseite des Grundkörpers, die nicht an dem zu kühlenden Element anliegt.

Es ist daher die Aufgabe der vorliegenden Erfindung, eine integrierte Kühlvorrichtung für eine elektrische und/oder elektronische Einheit zu liefern, mit der eine verläßliche Kühlung von Komponenten mit hoher Wärmeerzeugung durchgeführt werden kann, die flexibel an die jeweilige Form des zu kühlenden Gegenstandes sowie die übrigen geometrischen Rahmenbedingungen angepaßt werden kann, kostengünstig herstellbar ist, als ein Bauteil geliefert werden kann und Freiraum für die ästhetische Ausgestaltung der Außenwand des die elektrischen/elektronischen Komponenten umgebenden Gehäuses bietet.

Diese Aufgabe wird durch die Merkmale des Anspruchs 1 und durch die Merkmale des Anspruchs 2 gelöst.

Erfindungsgemäß wird eine Kühlvorrichtung für eine elektrische und/oder elektronische Einheit vorgeschlagen, mit einem wärmeleitenden Grundkörper, der zwei Stirnflächen und eine Mantelfläche aufweist und dazu geeignet ist, über eine Stirnfläche mit der zu kühlenden Einheit in Kontakt gebracht zu werden, mit einem Kühlprofilkörper, wobei sich zwischen Mantelfläche des Grundkörpers und Kühlprofilkörper ein gasdicht abgeschlossener, teilevakuierter Raumbereich befindet, und mit einem Vlies, das mit einer Flüssigkeit getränkt ist und auf der Mantelfläche des Grundkörpers angebracht ist, so daß im Betrieb die im Vlies enthaltene Flüssigkeit im Raumbereich verdampft, an der dem Raumbereich zugewandten Wand des Kühlprofilkörpers kondensiert und wieder dem Vlies zugeführt wird. Dabei ist der Kühlprofilkörper von einem Hüllelement derart umhüllt, dass mehrere kaminähnliche Luftschächte zwischen Kühlprofilkörper und Hüllelement ausgebildet sind. Der Kühlprofilkörper ist im wesentlichen als Tubus ausgebildet und seine Wand weist einen zickzackförmig der wellenförmig verlaufenden Querschnitt auf.

Denselben erfindungsgemäßen Gedanken liefert eine Kühlvorrichtung mit einem als Hohlkörper ausgebildeten, wärmeleitenden Grundkörper, der eine Innenwandfläche und eine Außenwandfläche aufweist und dazu geeignet ist, mit der zu kühlenden Einheit über die Außenwandfläche in Kontakt gebracht zu werden, mit einem Kühlprofilkörper, der sich derart im Inneren des Grundkörpers befindet, daß er von der Innenwandflächedes Grundkörpers zumindest teilweise umgeben ist, wobei sich zwischen Grundkörper und Kühlprofilkörper ein gasdicht abgeschlossener, teilevakuierter Raumbereich befindet, und mit einem Vlies, das mit einer Flüssigkeit getränkt ist und auf der Innenwandfläche des Grundkörpers angebracht ist, so daß im Betrieb die im Vlies enthaltene Flüssigkeit im Raumbereich verdampft, an der dem Raumbereich zugewandten Wand des Kühlprofilkörpers kondensiert und wieder dem Vlies zugeführt wird.

Mit einer derartigen erfindungsgemäßen Kühlvorrichtung ist es nunmehr möglich, selbst enorme Wärmemengen bei der Kühlung moderner elektrischer/elektronischer Einheiten, wie beispielsweise Prozessoren, sicher abzuführen, wobei gleichzeitig der Kostenfaktor sehr gering gehalten werden kann und die Außenwände des die elektrischen/elektronischen Einheiten umgebenden Gehäuses frei von Elementen der Kühlvorrichtung sind. Das System ist zudem flexibel gestaltbar und benötigt keine Wartung.

Durch die kaminähnlichen Lutfschächte wird der Abtransport der vom Kühlprofilkörper an die Umgebungsluft abgegebenen Wärme enorm verbessert, da die warme Luft in den Luftschächten nach oben steigt und gleichzeitig kühle Luft von unten nachströmt, so dass ein regelrechter Durchzug entsteht.

Um die Wärmeabgabeleistung noch mehr zu erhöhen, ist der Kühlprofilkörper im wesentlichen als Tubus ausgebildet, wobei seine Wand einen zickzackförmig oder wellenförmig verlaufenden Querschnitt aufweist.

Die erfindungsgemäße Kühlvorrichtung weist bevorzugterweise Formteile aus Kunststoff zwischen Kühlprofilkörper und Grundkörper auf, die den teilevakuierten Raumbereich nach oben und unten gasdicht abschließen. Verwendet man zusätzlich eine nichtleitende Flüssigkeit zur Wärmeübertragung, so kann die erfindungsgemäße Kühlvorrichtung auch direkt mit hochspannungsführenden Bauelementen wie Schalttransistoren, Thyristoren usw. verbunden werden.

Weitere Einzelheiten, Vorteile und Merkmale der vorliegenden Erfindung ergeben sich aus der nachfolgenden Beschreibung unter Bezugnahme auf die beigefügten Zeichnungen.

Diese zeigen:
- Fig. 1: eine Draufsicht auf eine erste Ausführungsform der erfindungsgemäßen Kühlvorrichtung;
- Fig. 2: einen Querschnitt gemäß A-A der Kühlvorrichtung aus Fig. 1;
- Fig. 3: eine Draufsicht auf eine zweite bevorzugte Ausführungsform der erfindungsgemäßen Kühlvorrichtung; und
- Fig. 4: einen Querschnitt gemäß B-B der Kühlvorrichtung aus Fig. 3.

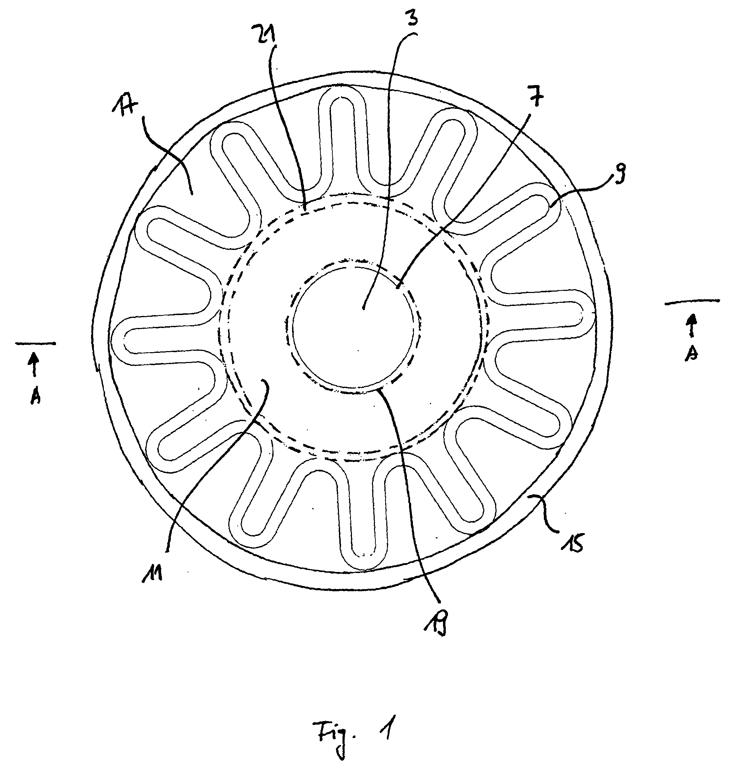

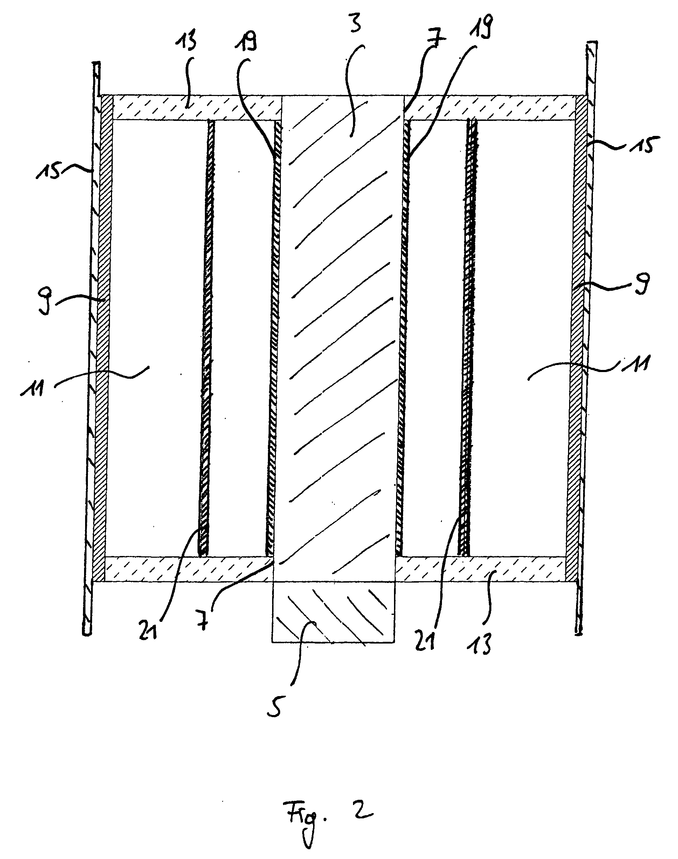

Fig. 1 und Fig. 2 zeigen eine erste bevorzugte Ausführungsform der vorliegenden Erfindung. Die Kühlvorrichtung weist einen Grundkörper 3 auf, der mit der zu kühlenden elektrischen/elektronischen Einheit 5 in Kontakt steht. Dies kann entweder direkt oder über eine weitere Wärmebrücke (nicht gezeigt) erfolgen. Der Grundkörper 3 ist in diesem Beispiel als Vollzylinder aus einem stark wärmeleitenden Material, etwa Aluminium oder Kupfer, ausgebildet und sollte an der Übergangsstelle mindestens die gleiche Grundfläche wie die Wärmequelle 5 aufweisen. Ebenso ist es jedoch möglich, den Grundkörper 3 als Vollkörper mit ovalem oder polygonalem Querschnitt auszubilden, ebenso als Hohlkörper mit nahezu beliebigen Wandformen. In jedem Fall weist der Grundkörper 3 eine Mantelfläche 7 auf, die ihn außenumfänglich umgibt.

In einigem Abstand um die Mantelfläche 7 des Grundkörpers 3 herum angeordnet befindet sich ein Kühlprofilkörper 9, der ebenfalls als Tubus ausgebildet ist, wobei seine Wand zu Zwecken der Oberflächenvergrößerung deformiert ist, im vorliegenden Beispiel durch wellenförmige Ausbuchtungen. Ebenso kommen jedoch sternförmige, zickzackförmige und alle weiteren Profilformen in Betracht, die eine ausreichende Oberfläche zur Kühlung liefern. Der Kühlprofilkörper 9 wird idealerweise so gestaltet, dass er eine maximale Oberfläche erreicht, und besteht aus einem Material mit guten Wärmeleiteigenschaften, beispielsweise Aluminium oder Kupfer.

Zwischen Kühlprofilkörper 9 und Grundkörper 3 befindet sich ein Raumbereich 11, der über als solches bekannte Vakuumpumpen bis zu einem gewissen Grad teilevakuiert ist. Im oberen bzw. unteren Bereich wird dieser Raumbereich 11 durch Formteile 13 gasdicht abgeschlossen, die zwischen Grundkörper 3 und Kühlprofilkörper 9 fixiert sind. Diese Formteile 13 bestehen bevorzugterweise aus einem harten Kunststoff und werden mit dem Kühlprofilkörper 9 und dem Grundkörper 3 beispielsweise durch gasdichte Verklebung verbunden, so dass das Teilvakuum auch über einen längeren Zeitraum erhalten bleibt. Zusätzlich können weitere für einen Fachmann bekannte abdichtende Maßnahmen ergriffen werden. Die Formteile 13 können selbstverständlich auch aus jedem geeigneten anderen Material, beispielsweise Metall, bestehen, die Verwendung von hartem Kunststoff bringt jedoch den Effekt mit sich, dass die Kühlvorrichtung auch zur Kühlung von hochspannungstragenden Komponenten 5 eingesetzt werden kann, ohne weitere Maßnahmen ergreifen zu müssen. Die Formteile müssen sehr exakt ausgearbeitet sein und weisen im Außenbereich dieselbe Form wie die Wandung des Kühlprofilkörpers 9 und im Innenbereich die Form des Grundkörpers 3 auf. Somit entsteht im vorliegenden Beispiel eine Art Blume mit kreisförmiger Mittelaussparung. Das Teilvakuum wird über ein geeignetes Ventil erzeugt und soll so hoch wie möglich sein, da bei stärkerem Vakuum der Siedepunkt von Flüssigkeiten tiefer liegt. Bevorzugterweise soll das Teilvakuum während der gesamten Lebensdauer der elektrischen/elektronischen Einheit 5 bestehen bleiben, es ist jedoch auch denkbar, dass in gewissen Zeitabstände eine Wiederholung des Evakuierungsprozesses vorgenommen wird.

Auf den Kühlprofilkörper 9 ist ein rohrförmiges Hüllelement 15 aufgesetzt, das den Kühlprofilkörper 9 umgibt und eng an dessen äußeren Wandausbuchtungen anliegt. Dieses rohrförmige Hüllelement 15 kann aus nahezu jedem beliebigen Material bestehen, ist aber bevorzugt als flexibler Schlauch ausgebildet, der über den Kühlprofilkörper 9 gestülpt wird. Dadurch entstehen zwischen jeweils zwei Ausbuchtungen des Kühlprofilkörpers 9 und dem rohrförmigen Hüllelement 15 kaminähnliche Luftschächte 17, die oben und unten jeweils eine Öffnung aufweisen, welche sich bevorzugt außerhalb eines Gehäuses (nicht gezeigt) befinden, welches die elektrischen/elektronischen Einheiten 5 umgibt. Die Länge der kaminähnlichen Luftschächte 17 und deren Weiterführung kann nahezu beliebig gestaltet werden und hängt in erster Linie von der Geometrie des Gehäuses ab, aus dem die Wärme hinaustransportiert werden muss.

Der Kühleffekt selbst wird durch eine Flüssigkeit geliefert, die im teilevakuierten Raumbereich 11 zwischen Grundkörper 3 und Kühlprofilkörper 9 eingebracht ist. Diese befindet sich zunächst in einem Vlies 19, das an der Mantelfläche 7 des Grundkörpers 3 durch Verklebung angebracht ist. Im Falle der Kühlung von hochspannungstragenden Komponenten 5 wird eine nichtleitende Flüssigkeit verwendet, bevorzugterweise destilliertes Wasser oder Alkohol, es lassen sich jedoch auch alle weiteren Flüssigkeiten verwenden, die zum Wärmetransport geeignet sind.

Schließlich ist direkt an den Innenausbuchtungen des Kühlprofilkörpers 9 innerhalb des teilevakuierten Raumbereichs 11 eine Gaze 21 angeordnet, die zum Abführen von kondensierter Flüssigkeit dient. Insbesondere bei Schrägstellung der Kühlvorrichtung dient sie dazu, die kondensierte Flüssigkeit wieder in den unteren Bereich der Kühlvorrichtung und somit auf das Vlies 19 zu transportieren. Hier kann beispielsweise eine Metallgaze eingesetzt werden, es sind aber auch viele andere Materialarten einsetzbar. Zudem kann auch die dem teilevakuierten Raumbereich 11 zugewandte Fläche des Kühlprofilkörpers 9 mit einer Vliesschicht (nicht gezeigt) bedeckt sein, die aufgrund ihrer Kapillarwirkung für den Abtransport des kondensierten Wasserdampfes sorgt.

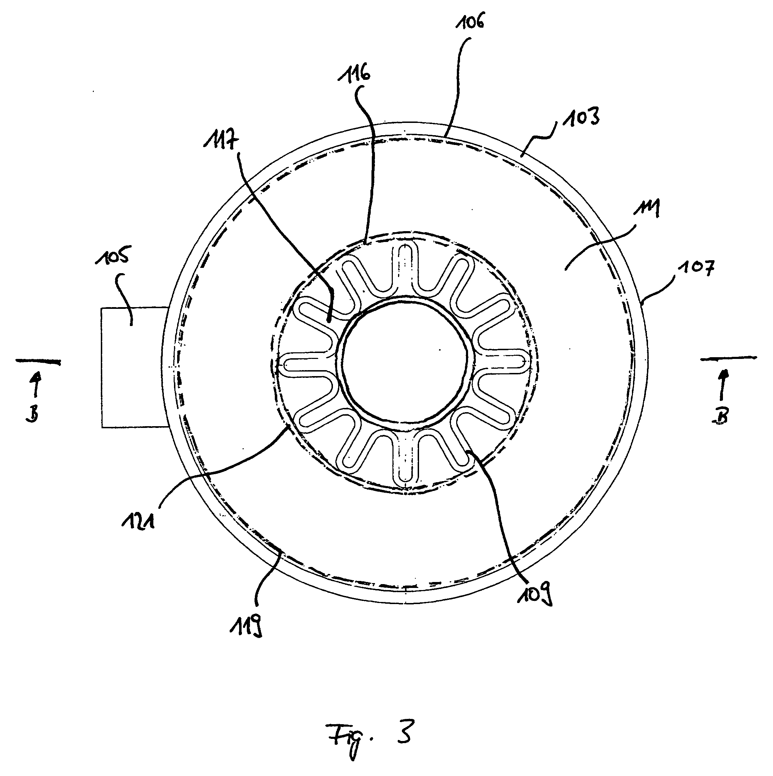

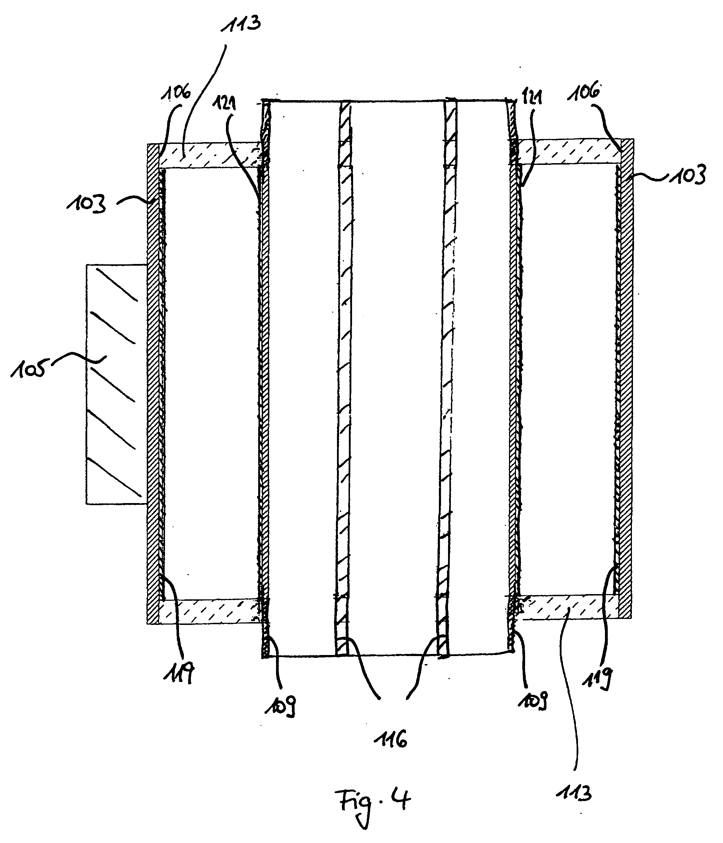

Fig. 3 und Fig. 4 zeigen eine zweite bevorzugte Ausführungsform der erfindungsgemäßen Kühlvorrichtung. Hinsichtlich der Materialien und räumlichen Ausgestaltung der Komponenten gilt dasselbe wie in der unter Bezugnahme auf Fig. 1 und Fig. 2 beschriebenen Ausführungsform, sofern nicht ausdrücklich anderes erwähnt ist. Der hier beschriebenen Ausführungsform liegt derselbe erfinderische Gedanke zugrunde. Wiederum wird ein Grundkörper 103 mit einer elektrischen/elektronischen Einheit 105 verbunden. Der Grundkörper 103 ist als Hohlkörper ausgebildet, bevorzugt als Hohlzylinder. Das Vlies 119 ist an einer Innenwandfläche 106 des Grundkörpers 103 angebracht. Der Kühlprofilkörper 109 hat einen geringeren Außendurchmesser und befindet sich derart im Inneren des Grundkörpers 103, dass er von der Innenwandfläche 106 des Grundkörpers 103 zumindest teilweise umgeben ist.

Zwischen Grundkörper 103 und Kühlprofilkörper 109 entsteht ein teilevakuierter Raumbereich 111 wie im ersten Ausführungsbeispiel, jedoch sind die zum gasdichten Abschluß nötigen Formteile 113, die den Grundkörper 103 mit dem Kühlprofilkörper 109 verbinden, an ihrem Außenrand an die Form des Grundkörpers 103 und am Innenrand an die Form des Kühlprofilkörpers 109 angepaßt.

Ein rohrförmiges Innenelement 116 ist in den Kühlprofilkörper 109 hineingesteckt und liegt eng an dessen nach innen gerichteten Ausbuchtungen an, so dass kaminähnliche Luftschächte 117 zwischen jeweils zwei inneren Ausbuchtungen des Kühlprofilkörpers 109 und dem rohrförmigen Innenelement 116 entstehen. Das rohrförmige Innenelement 116 besteht aus einem Material, das genug Steifigkeit aufweist, um im Inneren des Kühlprofilkörpers 109 stecken zu bleiben. Eine Gaze 121 liegt wiederum innerhalb des teilevakuierten Raumbereiches 111 eng am Kühlprofilkörper 109 an.

Im folgenden wird der Kühlprozeß gemäß der vorliegenden Erfindung erläutert. Zunächst erwärmt sich das wärmeerzeugende Element 5 bzw. 105 und gibt durch Konvektion Wärme an den Grundkörper 3 bzw. 103 ab. Dieser erwärmt sich hierdurch, und die im Vlies 19 bzw. 119 enthaltene Flüssigkeit verdampft im teilevakuierten Raumbereich 11 bzw. 111 bereits bei relativ niedrigen Temperaturen, da aufgrund des Vakuums die Siedetemperatur sinkt. Der Flüssigkeitsdampf diffundiert durch die Gaze 21 bzw. 121 hindurch und kondensiert an der dem teilevakuierten Raumbereich 11 bzw. 111 zugeordneten Wand des Kühlprofilkörpers 9 bzw. 109 ab, wobei Wärme an diesen abgegeben wird. Die abgekühlte, kondensierte Flüssigkeit läuft am Kühlprofilkörper 9 bzw. 109 wieder nach unten und wird wieder dem Vlies 19 bzw. 119 zugeführt. Dies kann entweder auf direktem Wege geschehen oder unter Verwendung geeigneter Kapillarstrukturen, wie beispielsweise einem weiteren Vlies. Die Gaze 21 bzw. 121 verhindert, dass bei Schrägstellung Tropfen der kondensierten Flüssigkeit direkt in den teilevakuierten Raumbereich 11 bzw. 111 zurückfallen. Dieser Wärmeübertragungsmechanismus über verdampfte Flüssigkeit ist äußerst wirksam und liefert einen großen Wärmeübertrag, ohne dass im System selbst hohe Temperaturen herrschen.

Der Kühlprofilkörper erwärmt sich durch die bei der Kondensation abgegebene Wärme aus dem Dampf und gibt seine Wärme wiederum an die Umgebungsluft weiter. Diese Luft erwärmt sich und steigt in den kaminähnlichen Luftschächten 17 bzw. 117 nach oben, während von unten kühle Luft in diese nachströmt, so dass eine starke Sogwirkung entsteht.

Schließlich ist es auch denkbar, mehrere dieser Kühlvorrichtungen in Reihe zu verwenden, um die Wärmeabführung nochmals zu steigern.

Eine noch bessere Kühlwirkung wird erzielt, wenn das Vlies direkt (ohne Zwischenschaltung eines Grundkörpers) auf den zu kühlenden Körper aufgebracht wird, weil dadurch die Wärmeleitung zwischen zu kühlendem Körper und Grundkörper als limitierender Faktor für die Wärmeabfuhr wegfällt. Hierfür muss der zu kühlende Körper eine geeignete Geometrie aufweisen.

Somit wird eine Kühlvorrichtung geschaffen, die auch in luft-, staub- und wasserdichten Systemen einsetzbar ist, die Verlustleistungen von über 150 W immer noch sicher abführen kann und relativ kostengünstig herstellbar ist. Natürlich ist dieses Prinzip einer integrierten Kühlvorrichtung ohne Lüfter nicht auf die exakte Ausführungsform beschränkt, wie sie in der bisherigen Beschreibung offenbart ist. Vielmehr ist es beispielsweise auch möglich, lediglich Teile des Grundkörpers mit einem Vlies zu überziehen bzw. den Grundkörper lediglich in Teilbereichen vom Kühlprofilköper umgeben zu lassen bzw. umgekehrt. Ebenso ist es denkbar, dass die erfindungsgemäße Kühlvorrichtung auch zur Rückgewinnung von Abwärme aus mit Schadstoffen belasteten Gasen und Flüssigkeiten bzw. zur Gewinnung von Wärme, die bei biologischen Prozessen entsteht, verwendet werden kann. Hierfür ist insbesondere die zweite bevorzugte Ausführungsform geeignet, da sie einen Grundkörper mit großer Wärmeaufnahmefläche zeigt. Insgesamt kann die erfindungsgemäße Kühlvorrichtung flexibel an alle äußeren Rahmenbedingungen angepaßt werden. Es wird somit eine integrierte Lösung geschaffen, die äußerst platzsparend ist und wartungsfrei sowie umweltfreundlich funktioniert.

## Patentansprüche

1. Kühlvorrichtung für eine elektrische und/oder elektronische Einheit (5), mit einem wärmeleitenden Grundkörper (3), der zwei Stirnflächen und eine Mantelfläche (7) aufweist und dazu geeignet ist, über eine Stirnfläche mit der zu kühlenden Einheit (5) in Kontakt gebracht zu werden, mit einem Kühlprofilkörper (9), wobei sich zwischen Mantelfläche des Grundkörpers (3) und Kühlprofilkörper (9) ein gasdicht abgeschlossener, teilevakuierter Raumbereich (11) befindet, und mit einem Vlies (19), das mit einer Flüssigkeit getränkt ist und auf der Mantelfläche (7) des Grundkörpers (3) angebracht ist, so daß im Betrieb die im Vlies (19) enthaltene Flüssigkeit im Raumbereich (11) verdampft, an der dem Raumbereich (11) zugewandten Wand des Kühlprofilkörpers (9) kondensiert und wieder dem Vlies (19) zugeführt wird,
**dadurch gekennzeichnet, dass** der Kühlprofilkörper (9, 109) im wesentlichen als Tubus ausgebildet ist, wobei seine Wand einen zickzackförmig oder wellenförmig verlaufenden Querschnitt aufweist, und dass
der Kühlprofilkörper (9) von einem Hüllelement (15) derart umhüllt ist, dass mehrere kaminähnliche Luftschächte (17) zwischen Kühlprofilkörper (9) und Hüllelement (15) ausgebildet sind.

2. Kühlvorrichtung für eine elektrische und/oder elektronische Einheit (105), mit einem als Hohlkörper ausgebildeten, wärmeleitenden Grundkörper (103), der eine Innenwandfläche (106) und eine Außenwandfläche (107) aufweist und dazu geeignet ist, mit der zu kühlenden Einheit (105) über die Außenwandfläche (107) in Kontakt gebracht zu werden, mit einem Kühlprofilkörper (109), der sich derart im Inneren des Grundkörpers (103) befindet, daß er von der Innenwandfläche (106) des Grundkörpers (103) zumindest teilweise umgeben ist, wobei sich zwischen Grundkörper (103) und Kühlprofilkörper (109) ein gasdicht abgeschlossener, teilevakuierter Raumbereich (111) befindet, und mit einem Vlies (119), das mit einer Flüssigkeit getränkt ist und auf der Innenwandfläche (106) des Grundkörpers (103) angebracht ist, so daß im Betrieb die im Vlies (119) enthaltene Flüssigkeit im Raumbereich (111) verdampft, an der dem Raumbereich (111) zugewandten Wand des Kühlprofilkörpers (109) kondensiert und wieder dem Vlies (119) zugeführt wird.

3. Kühlvorrichtung nach Anspruch 1, **dadurch gekennzeichnet, dass** der Grundkörper (3) im wesentlichen als Vollzylinder ausgebildet ist.

4. Kühlvorrichtung nach Anspruch 2, **dadurch gekennzeichnet, dass** ein rohrförmiges Innenelement (116) in den Kühlprofilkörper (109) derart eingesetzt ist, dass zwischen Kühlprofilkörper (109) und rohrförmigem Innenelement (116) mehrere, von dem Kühlprofilkörper (109) und dem rohrförmigen Innenelement (116) begrenzte, kaminähnliche Luftschächte (117) ausgebildet sind.

5. Kühlvorrichtung nach Anspruch 2 oder 4, **dadurch gekennzeichnet, dass** der Grundkörper (103) im wesentlichen als Hohlzylinder ausgebildet ist.

6. Kühlvorrichtung nach einem der vorangehenden Ansprüche, **dadurch gekennzeichnet, dass** Formteile (13, 113) aus Kunststoff zwischen Kühlprofilkörper (9, 109) und Grundkörper (3, 103) angeordnet sind, die den teilevakuierten Raumbereich (11, 111) nach oben und unten gasdicht abschließen.

## Claims

1. Cooling device for an electric and/or electronic unit (5), with a thermally conductive base body (3), which has two end faces and a shell surface (7) and is suitable to be brought into contact with the unit (5) to be cooled via one end face, with a cooling profile body (9), wherein a partially evacuated area (11) closed to be gastight is located between the shell surface of the base body (3) and the cooling profile body (9), and with a fibrous web (19), which is impregnated with a liquid and is attached to the shell surface (7) of the base body (3), so that during operation the liquid contained in the fibrous web (19) in the area (11) evaporates, condenses on the wall of the cooling profile body (9) facing the area (11) and is fed again to the fibrous web (19), **characterised in that** the cooling profile body (9, 109) is configured essentially as a tube, wherein its wall has a cross-section running in a zigzag or undulating shape, and that the cooling profile body (9) is enveloped by an enveloping element (15) such that several flue-like air shafts (17) are configured between the cooling profile body (9) and the enveloping element (15).

2. Cooling device for an electric and/or electronic unit (105), with a thermally insulating base body (103) configured as a hollow body, which has an inside wall face (106) and an outside wall face (107) and is suitable to be brought into contact with the unit (105) to be cooled via the outside wall face (107), with a cooling profile body (109), which is located in the interior of the base body (103) in such a manner that it is at least partially surrounded by the inside wall face (106) of the base body (103), wherein a partially evacuated area (111) closed to be gastight is located between the base body (103) and the cooling profile body (109), and with a fibrous web (119), which is impregnated with a liquid and is attached to the inside wall face (106) of the base body (103), so that during operation the liquid contained in the fibrous web (119) in the area (111) evaporates, condenses on the wall of the cooling profile body (109) facing the area (111) and is fed again to the fibrous web (119).

3. Cooling device according to Claim 1, **characterised in that** the base body (3) is essentially configured as a full cylinder.

4. Cooling device according to Claim 2, **characterised in that** a tubular inside element (116) is inserted into,the cooling profile body (109) in such a way that several flue-like air shafts (117) defined by the cooling profile body (109) and the tubular inside element (116) are configured between the cooling profile body (109) and the tubular inside element (116).

5. Cooling device according to Claim 2 or 4, **characterised in that** the base body (103) is essentially configured as a hollow cylinder.

6. Cooling device according to one of the preceding claims, **characterised in that** plastic shaped parts (13, 113) are arranged between the cooling profile body (9, 109) and the base body (3, 103), which seal the partially evacuated area (11, 111) to the top and bottom to be gastight.

## Revendications

1. Dispositif de refroidissement pour une unité électrique et/ou électronique (5), comportant un corps de base (3) conducteur de chaleur qui présente deux surfaces frontales et une surface d'enveloppe (7) et est approprié pour être amené au contact de l'unité à refroidir (5) par l'intermédiaire d'une surface frontale, un corps profilé de refroidissement (9), une zone spatiale (11) sous vide partiel, fermée de façon étanche aux gaz, se situant entre la surface d'enveloppe du corps de base (3) et le corps profilé de refroidissement (9), et un non-tissé (19) imprégné d'un liquide et placé sur la surface d'enveloppe (7) du corps de base (3) de telle sorte que, en cours de service, le liquide contenu dans le non-tissé (19) s'évapore dans la zone spatiale (11), se condense sur la paroi du corps profilé de refroidissement (9) tournée vers la zone spatiale (11) et est de nouveau envoyé au non-tissé (19), **caractérisé en ce que** le corps profilé de refroidissement (9, 109) est configuré sensiblement sous forme de tube, sa paroi présentant une section transversale en zigzag ou en forme d'onde, et que le corps profilé de refroidissement (9) est enveloppé par un élément de gaine (15) de telle sorte que plusieurs puits d'air (17) analogues à des cheminées sont réalisés entre le corps profilé de refroidissement (8) et l'élément de gaine (15).

2. Dispositif de refroidissement pour une unité électrique et/ou électronique (105), comportant un corps de base (103) conducteur de chaleur configuré sous forme de corps creux, qui présente une surface de paroi intérieure (106) et une surface de paroi extérieure (107) et est approprié pour être amené au contact de l'unité à refroidir (105) par l'intermédiaire de la surface de paroi extérieure (107), un corps profilé de refroidissement (109), qui se situe à l'intérieur du corps de base (103) de telle sorte qu'il est enveloppé, au moins partiellement, par la surface de paroi intérieure (106) du corps de base (103), une zone spatiale (111) sous vide partiel, fermée de façon étanche aux gaz, se situant entre le corps de base (103) et le corps profilé de refroidissement (109), et un non-tissé (119) imprégné d'un liquide et placé sur la surface de paroi intérieure (106) du corps de base (103) de telle sorte que, en cours de service, le liquide contenu dans le non-tissé (119) s'évapore dans la zone spatiale (111), se condense sur la paroi du corps profilé de refroidissement (109) tournée vers la zone spatiale (111) et est de nouveau envoyé au non-tissé (119).

3. Dispositif de refroidissement suivant la revendication 1, **caractérisé en ce que** le corps de base (3) est configuré sensiblement sous forme de cylindre plein.

4. Dispositif de refroidissement suivant la revendication 2, **caractérisé en ce qu'**un élément intérieur tubulaire (116) est mis en place dans le corps profilé de refroidissement (109) de telle sorte que plusieurs puits d'air (117) analogues à des cheminées, limités par le corps de refroidissement profilé (109) et par l'élément intérieur tubulaire (116), sont réalisés entre le corps profilé de refroidissement (109) et l'élément intérieur tubulaire (116).

5. Dispositif de refroidissement suivant l'une des revendications 2 et 4, **caractérisé en ce que** le corps de base (103) est configuré sensiblement sous forme de cylindre creux.

6. Dispositif de refroidissement suivant l'une des revendications précédentes, **caractérisé en ce que** des pièces moulées (13, 113) en matière plastique sont disposées entre le corps profilé de refroidissement (9, 109) et le corps de base (3, 103), qui ferment de façon étanche.aux gaz vers le haut et vers le bas la zone spatiale (11, 111) sous vide partiel.
